# EUROPEAN PATENT SPECIFICATION

(11) **EP 0 856 224 B1**
(45) Date of publication and mention of the grant of the patent: **07.12.2005**
(21) Application number: 96936734.1
(22) Date of filing: 17.10.1996
(51) Int. Cl.: H04N 5/782, H04N 7/167

(54) **METHOD AND APPARATUS FOR REMOVING OR DEFEATING EFFECTS OF COPY PROTECTION SIGNALS FROM A VIDEO SIGNAL**
VERFAHREN UND VORRICHTUNG ZUR ENTFERNUNG ODER UNTERDRÜCKUNG VON KOPIERSCHUTZSIGNALEFFEKTEN VON/IN EINEM VIDEOSIGNAL
PROCEDE POUR ENLEVER OU RENDRE INOPERANTES DES IMPULSIONS DE PROTECTION CONTRE LA COPIE D'UN SIGNAL VIDEO, ET DISPOSITIF ASSOCIE

(30) Priority: 17.10.1995 US 5681 P
(43) Date of publication of application: 05.08.1998
(60) Divisional application: 04001551.3
(73) Proprietor: MACROVISION CORPORATION, Santa Clara, CA 95050 (US)
(72) Inventor: QUAN, Ronald, Cupertino, CA 95014 (US)
(74) Representative: Needle, Jacqueline
(86) International application number: PCT/US1996/016783
(87) International publication number: WO 1997/015142

(56) References cited:
- EP-A- 0 128 771
- US-A- 4 695 901
- US-A- 4 819 098
- US-A- 5 058 157
- US-A- 5 157 510

## Description

The present invention relates to a method and apparatus for removing the effects of copy protection signals from a video signal.

US-A-4,631,603 ('603) describes a video signal that is modified so that a television receiver will still provide a normal color picture from the modified video signal whilst a videotape recording of the modified video signal produces generally unacceptable pictures.

The copy protection system described in '603 relies on the fact that a typical video cassette recorder's automatic gain control system cannot distinguish between the normal sync pulses (including equalizing or broad pulses) of a conventional video signal and added pseudo-sync pulses. Pseudo-sync pulses are defined here as pulses which extend down to a normal sync tip level and which have a duration of at least 0.5 microseconds. A plurality of such pseudo-sync pulses is added to the conventional video during the vertical blanking interval, and each of the pseudo-sync pulses is followed by a positive pulse of suitable amplitude and duration. As a result, the automatic gain control system in a videotape recorder will make a fake measurement of video level which causes an improper recording of the video signal. The result is unacceptable picture quality during playback.

US-A-4,819,098 ('098) describes a signal modification which enables a television monitor receiver still to produce a normal picture from the modified signal, whereas a videotape recording of this signal produces generally unacceptable pictures. Videotape recorders have an automatic gain control circuit which measures the sync level in a video signal and develops a gain correction for keeping the video level applied to an FM modulator in the videotape recording system at a fixed, predetermined value. In this system, a plurality of positive pulses are added to a video signal with each immediately following a respective trailing edge of a normally occurring sync pulse. These added pulses are clustered at the vertical blanking interval of each field to minimize the effect of the same on the viewability of the picture defined by the signal while still causing the automatic level control circuit in a recorder to assess the video level at many times its actual value. The sync pulses themselves can also be at a reduced level, in order to enhance the effectiveness of the process.

US-A-4 695 901 ('901) describes the removal of pseudo-sync pulses and AGC pulses that have been added to a video signal to enable acceptable video recording thereof. That is, 901 describes a method of defeating copy protection schemes as set out above. Specifically, '901 discloses the use of a selectively-operable clipping circuit to remove selected negative-value components (i.e. pseudo-sync pulses) from the video signal, while added AGC pulses are effectively blanked from the video signal with an electrically-operated switch. Both the blanking and clipping functions are selectively achieved by sensing both the normal sync pulses of the video signal and the added pseudo-sync pulses.

US-A-4,336,554 ('554) describes a code signal blanking apparatus comprising a switching means operative during a given period of a vertical blanking period of a television signal and a reference level setting means for producing an output of the reference level during said given period when the switching circuit is operative.

US-A-5,194,965 ('965) describes a method and apparatus for disabling the effect of copy-protection signals which is based on differences in the characteristics of television and VCR circuitry. '965 describes a method in which the level of the video signal during the vertical blanking interval is altered, e.g. by level-shifting, so as to render the copy-protect signals ineffective to prevent unauthorized copying by a VCR.

US-A-5,157,510 ('510) also describes a defeat method which utilises differences in the characteristics of television and VCR circuitry. In this method, the effective frequency of the copy-protect signals is increased during the vertical blanking intervals so as to achieve attenuation and/or low pass filtering in the VCR circuitry to thereby render the signals ineffective in preventing copying.

US-A-4,571,615 ('615) discloses a timing signal generator for recovering timing signals in scrambled video signals in which the synchronizing signals are suppressed. The vertical interval is detected as the absence of color burst or chroma in the horizontal blanking interval for a specified time interval, and horizontal sync information is obtained by the detection of the first color burst or chroma in the horizontal blanking interval after an absence of color burst or chroma in the horizontal blanking interval.

All of the defeat methods described in the patents discussed above use vertical and horizontal synchronizing pulses to determine the location of the copy protection signals within a copy protected video signal. There is a need for copy protection defeat mechanisms which do not rely upon the horizontal and vertical synchronizing pulses to determine the location of the copy protection signals.

US-A-4571615 refers to scrambling and descrambling techniques for video signals. It identifies that the detection of color burst following the absence of color burst for a certain interval can be used to identify the occurrence of a vertical interval.

The present invention seeks to provide a method of defeating the effect of copy protection which does not rely upon the horizontal and vertical synchronising pulses to determine the location of the copy protection signals.

According to a first aspect of the present invention there is provided a method of removing the effects of pseudo sync and AGC pulse copy protection signals within video lines of a video signal having normal sync pulses including a color burst signal, the copy protection signals being for inhibiting the making of acceptable video recordings of the video signal whilst still allowing the video signal to be viewed, the method comprising the steps of:
determining the presence of a color burst signal to determine which video lines contain said copy protection signals;
generating a control signal during the presence of the copy protection pulses in said video lines, in response to determining the presence of the color burst signal; and
modifying the copy protection signals in response to the control signal in a number of the respective video lines sufficient to allow an acceptable video recording of the video signal to be made.

An embodiment of a method of the invention has two basic elements: a method for locating the video lines having the copy protection signals using a color burst or chroma in the horizontal blanking interval signal; and a method for modifying the copy protection signals in at least some of those located lines whereby an acceptable video recording of the video signal can be made.

The present invention also extends to apparatus for removing the effects of pseudo sync and AGC pulse copy protection signals within video lines of a video signal having normal sync pulses including a color burst signal, the copy protection signals being for inhibiting the making of acceptable video recordings of the video signal whilst still allowing viewing of the video signal, the apparatus comprising:
a location circuit responsive to the color burst signal for determining the presence of the color burst signal to determine which video lines contain said copy protection signals;
a logic circuit responsive to the location circuit for generating a control signal indicative of the presence of the copy protection signals in said determined video lines; and
a copy protection modification circuit for modifying the copy protection signals in a number of the determined video lines sufficient to allow an acceptable video recording of the video signal to be made.

In an embodiment of apparatus of the invention the copy protection modification circuit is generally "Circuit ACP" which is controlled by the pseudo sync AGC pulse pixel location circuit which uses the color burst or chroma on the horizontal blanking interval signal as a trigger.

This "Circuit ACP" eliminates or reduces the effectiveness of the copy protection signals by a) Level shifting and/or pulse narrowing and/or pulse attenuation; b) Normal composite sync replacement; c) Increased normal composite sync size that is larger in amplitude than the pseudo sync such that sync separators will not detect pseudo syncs; and/or d) Replacement of at least part of pseudo AGC locations with a signal (i.e. flat field) such that a recordable copy is possible.

Several different circuits which may be used within "Circuit ACP" are described.

Embodiments of the present invention will hereinafter be described, by way of example, with reference to the accompanying drawings, in which:
Figures 1A, 1B and 1C shows the vertical interval of standard NTSC video signal;
Figure 2 shows a copy protected signal including pseudo sync pulses and AGC pulses;
Figure 3 shows an altemative copy protection signal;
Figure 4 shows a general block diagram of a first embodiment of a location and modification apparatus of the invention;
Figure 5 shows a voltage controlled amplifier or modulator embodiment of "Circuit ACP" depicted in Figure 4;
Figure 6 shows a switch to modify copy protection pulses as another embodiment of "Circuit ACP" depicted in Figure 4;
Figure 7 shows a summing amplifier embodiment of "Circuit ACP" depicted in Figure 4;
Figure 8 shows a combination of circuits as shown in Figures 5, 6, and 7; and
Figure 9 shows a block diagram of a second embodiment of apparatus of the invention.

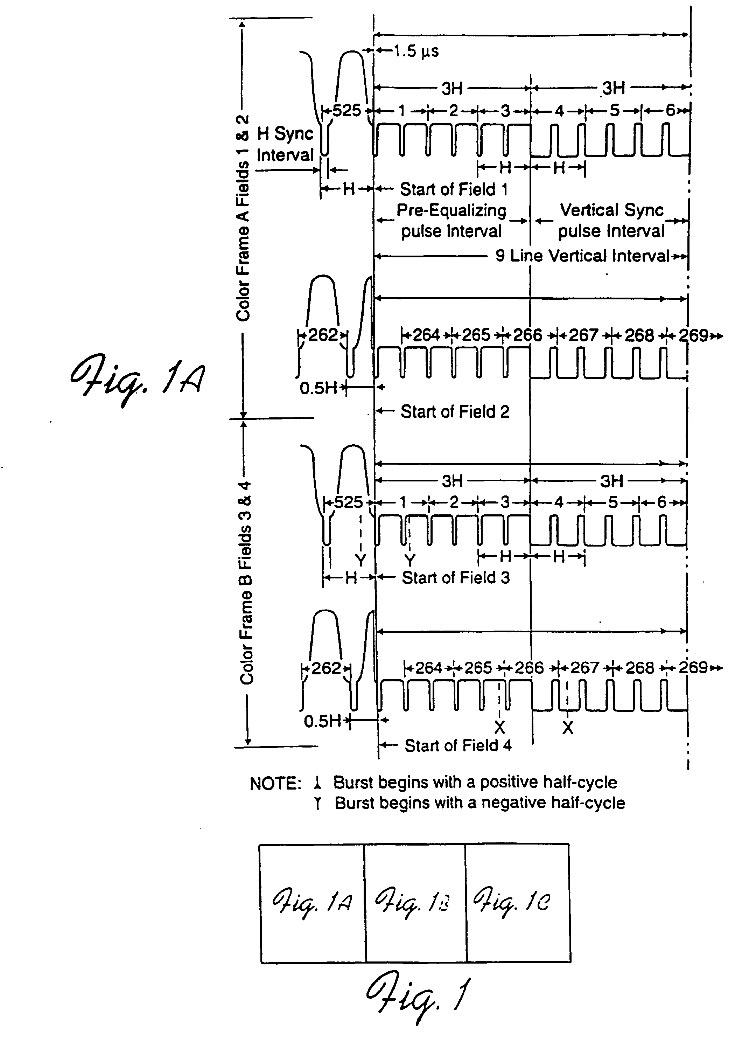

A method of the invention is arranged to locate and defeat or reduce the effectiveness of copy protection signals. Figures 1A, 1B and 1C show the vertical interval of a standard NTSC video signal. Note that the color burst or chroma in the horizontal blanking interval signal is not present during the first nine lines of each field.

There are two basic types of copy protection signals that are commonly present in video signals. The first includes signals in the vertical blanking portion of the video signal. The second which will be discussed below includes copy protection signals in the back porch portion of the video signal.

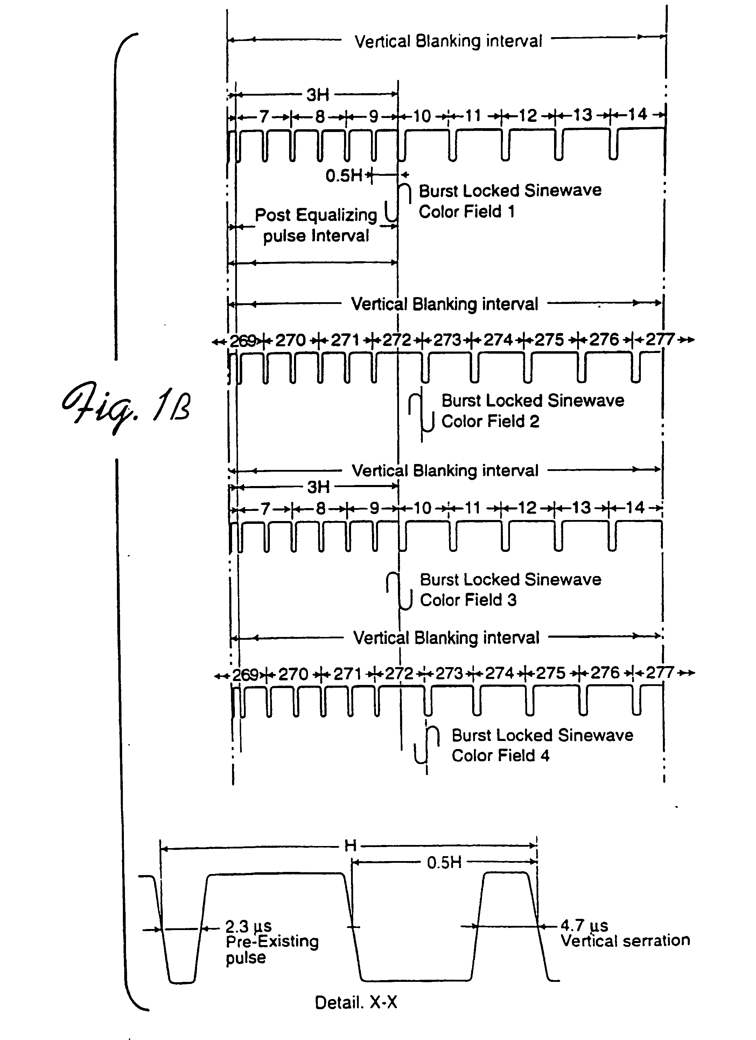

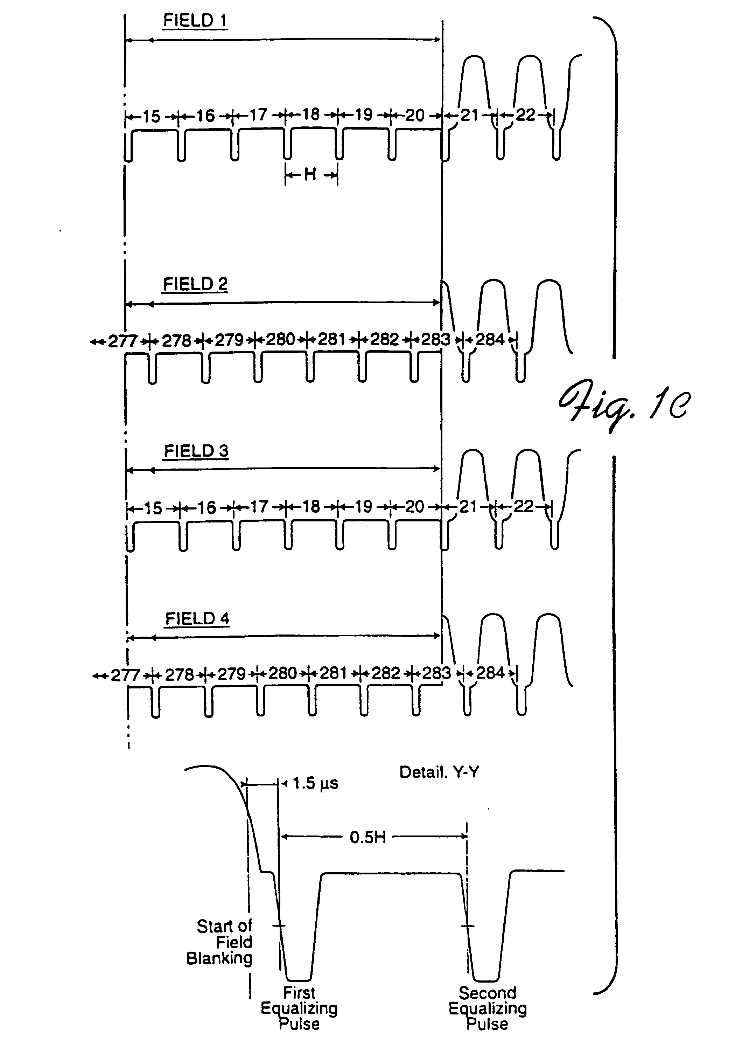

Figure 2 shows one horizontal line within a vertical blanking interval of the copy protection signal including pseudo sync pulses and AGC pulses as described in the '603 patent. The key element of this signal as described in the '603 patent is the relationship of the pseudo sync pulse with the AGC pulse. This relationship is the cause of the AGC disturbance in a recorder recording the copy protected signal.

The elements of these copy protection signals are the combination of either a pseudo sync or a regular sync pulse with an AGC pulse. These pairs of sync and AGC pulses are designed to cause the AGC circuitry in a recorder to miscalculate the proper gain setting and thus make an inferior recording. As described below, methods of the invention seek to locate the copy protection signals using the color burst signal and to modify the video signal to reduce or eliminate the effects of the copy protection signals.

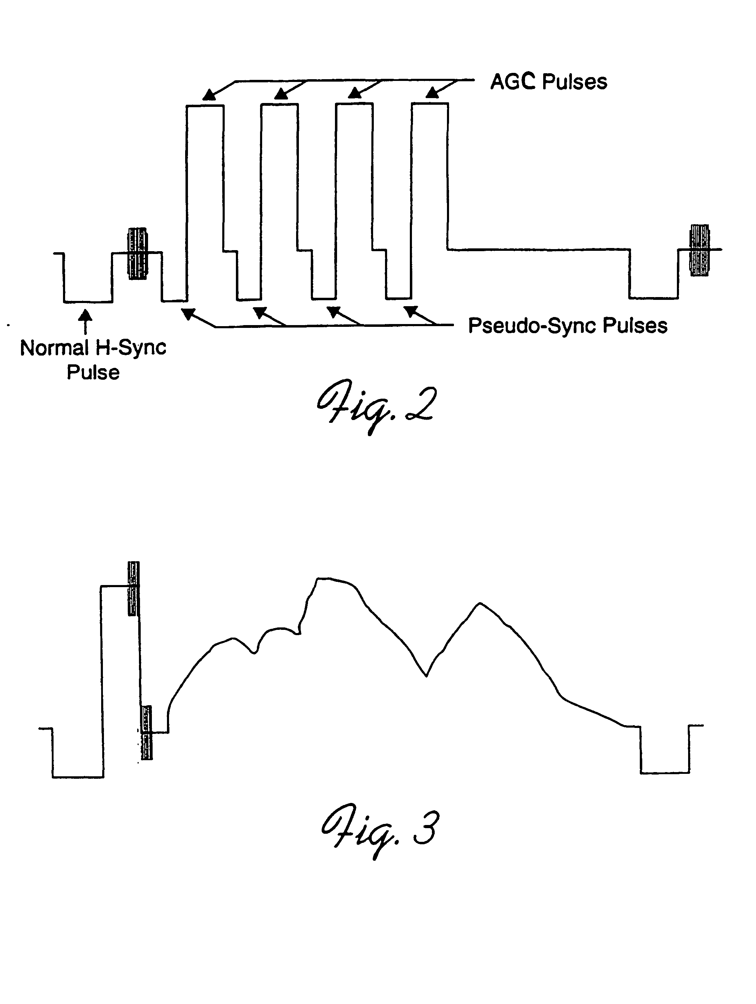

Figure 3 shows a commercial embodiment of a copy protection signal as described in the '098 patent. This signal is placed on several horizontal lines prior to the pre-equalizing pulses of the vertical interval in each field. The combination of these pulses with the pulses in Figure 2 increases the effectiveness of the copy protection without reducing the playability of the signal on a display device.

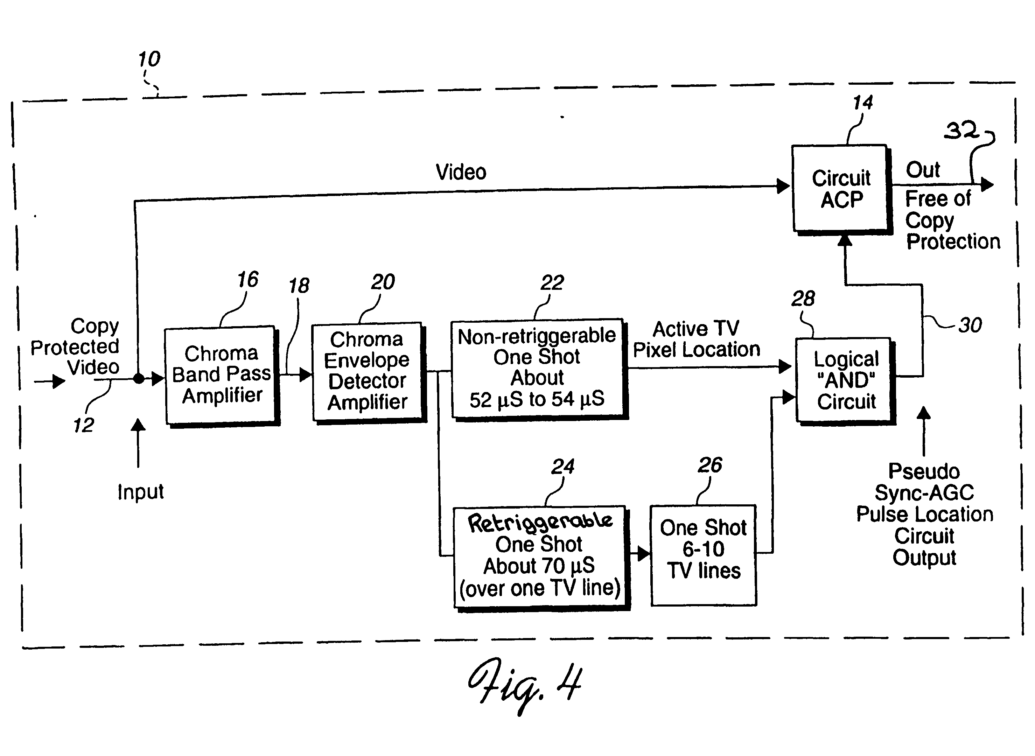

Figure 4 is an over all block diagram of an embodiment of a detection and modification circuit of the invention. This embodiment comprises two primary elements. The first of these is a pseudo sync AGC pulse location circuit which differs from detection circuits described in the '901, '965 and '510 patents. The second element is a "Circuit ACP" which modifies the copy protection signal under the control of control pulses generated by the location circuitry.

As discussed above, the vertical and horizontal synchronizing signals within the video signal have previously been utilised to detect the location of copy protection pulses. The methods described herein sense color burst or chroma to detect the copy protection pulses. As noted above, the color burst or chroma in the horizontal blanking interval signal is not present in the first nine lines of each field. The copy protection pulses are in known locations relative to the period containing no color burst or chroma in the horizontal blanking interval signals.

Figure 4 shows a copy protection pulse location and modification circuit which relies on color burst or chroma in the horizontal blanking interval to detect copy protection pulses.

The copy protection pulse location and modification circuit 10 shown in Figure 4 has an input to which a copy protected video signal 12 may be applied. The video signal 12 at the input is applied to a "Circuit ACP" 14 and to a chroma band pass amplifier 16. Chroma band pass amplifier 16 separates the chroma signal from the luminance signal. The chroma signal 18 output from the amplifier 16 is coupled to a chroma envelope detector amplifier 20.

As shown in Figures 1A, 1B and 1C, the color burst or chroma in the horizontal blanking interval signal is missing for about 9 lines in the vertical blanking interval. The circuitry of Figure 4 takes advantage of this. The output of the chroma envelope detector amplifier 20 is coupled to a non-retriggerable one shot 22 (timing circuit) of about 52 microseconds to 54 microseconds (less than one TV line). This ensures that the output of this circuit triggers only burst and not chroma in the active TV line and field. The output of the chroma envelope detector amplifier 20 goes also to a retriggerable one shot 24 (timing circuit) of about 70 microseconds (greater than one line). The interval of the one shot 24 should be greater than 1 TV line but preferably less than 2 TV lines, i.e. less than 126 microseconds. The output of this 70 microsecond one shot is a pulse which is held high from about line 10 to the end of the TV field (and is possibly high for 1 line into the next TV field). Since the AGC pulses and pseudo sync pulses are known to be for lines 10 through 16 or 20, 6-10 TV Line one shot 26 applies the low to high transition of the 70 microsecond one shot 24 into a logical 'AND' circuit 28 to which the output of the 52-54 microsecond one shot 22 (active pixel location) is also applied. The output of the "AND" circuit 28 is a control signal 30 applied to control the 'Circuit ACP' 14 so as to attenuate, clip, blank, level shift, enlarge normal sync pulses relative to pseudo sync pulses, narrow and modify the copy protection pulses sufficiently as to allow a recordable copy into a video tape recorder.

Note the concepts of Figure 4, while in the analog domain, also apply in the digital domain.

As illustrated, the copy protected video signal applied at input 12 of the circuit of Figure 4 is applied to a first input of Circuit ACP 14 to be modified by the Circuit ACP 14. The control signal 30 is applied to a second input of the Circuit ACP 14.

A first embodiment of Circuit ACP 14 uses a voltage controlled amplifier or modulator to increase the gain during the normal composite sync pulses and video outside the VBI but excluding the pseudo syncs. During the pseudo sync and/or AGC pulses the gain can be turned down. This is done by way of the control signal 30.

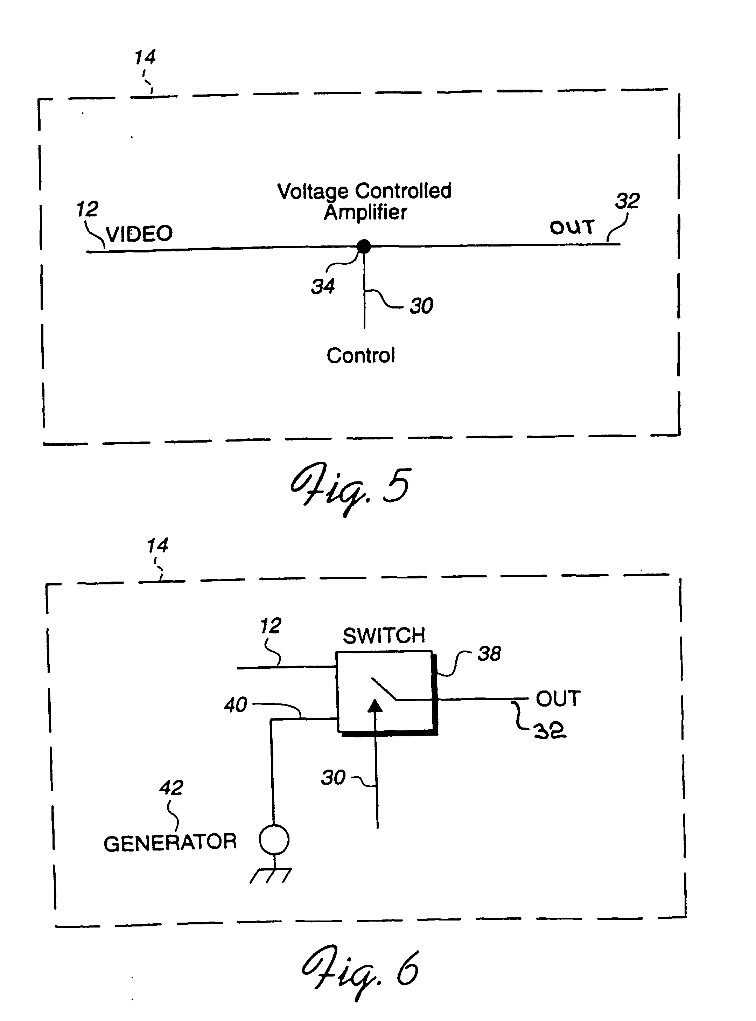

Figure 5 shows an example of a Circuit ACP 14 incorporating a voltage controlled amplifier. The copy protected video signal 12 is applied to an input of voltage controlled amplifier 34, and the control signal 30 is input to the control element of voltage controlled amplifier 34. This produces a voltage controlled output which will perform the various functions described above. The voltage controlled amplifier 34 may be used to change the relative position of the pseudo sync pulses to the normal sync pulses, for example, by level shifting up the pseudo-sync pulses. This prevents the pseudo-sync pulses from being detected. Thus, changing of the relative position of normal sync pulses to the pseudo sync pulses will cause a recorder not to respond to the pseudo sync pulses. In this respect, where the pseudo-sync pulses are shifted up, the recorder responds only to the normal vertical sync pulses since they are the only negative-going pulses sensed relative to the reference level (black voltage level).

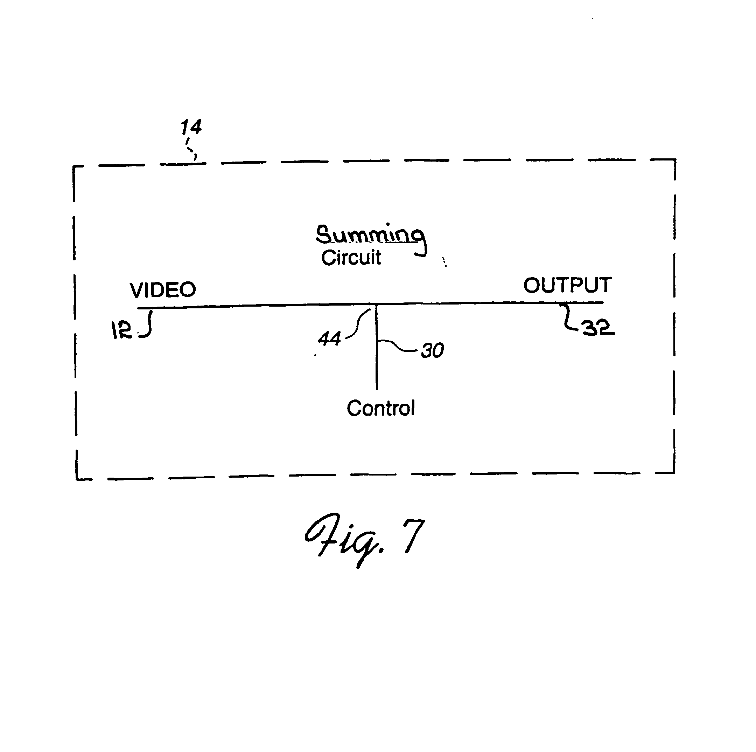

Figure 6 shows another embodiment of Circuit ACP 14 which uses a switch and a signal generator to modify the copy protection added pulses. For instance, if the signal generator produces a signal representing a blanking level, the control signal can be used to replace the added pulses with a signal that allows a recordable copy. The signal generator may be used to generate any signal including random noise or a test signal, or some variations of the input signal may include a modified version (i.e. narrowed pseudo sync pulses or AGC pulses, level shifted copy protection pulses, enlarged sync pulses and/or a filtered version of the copy protection pulses may be used (i.e. bandpass, low pass, high pass) so as to produce distorted copy protection pulses. This signal would replace or modify the copy protection signals so as to allow a recordable copy.

Figure 6 shows Circuit ACP 14 with such a switch generator combination. The copy protected video signal 12 is applied to an input of a switch 38. Control signal 30 is applied to the control element of the switch 38. The second signal input to the switch 38 is a video signal 40 which is generated by a generator 42. By the use of the switch 38 and the generator 42, copy protection pulses within the input video signal 12 are replaced with a blanking level signal or some other signal i.e: modified part or all of copy protection signals or test signal, thus permitting normal recording of the input video signal 12 by a recorder.

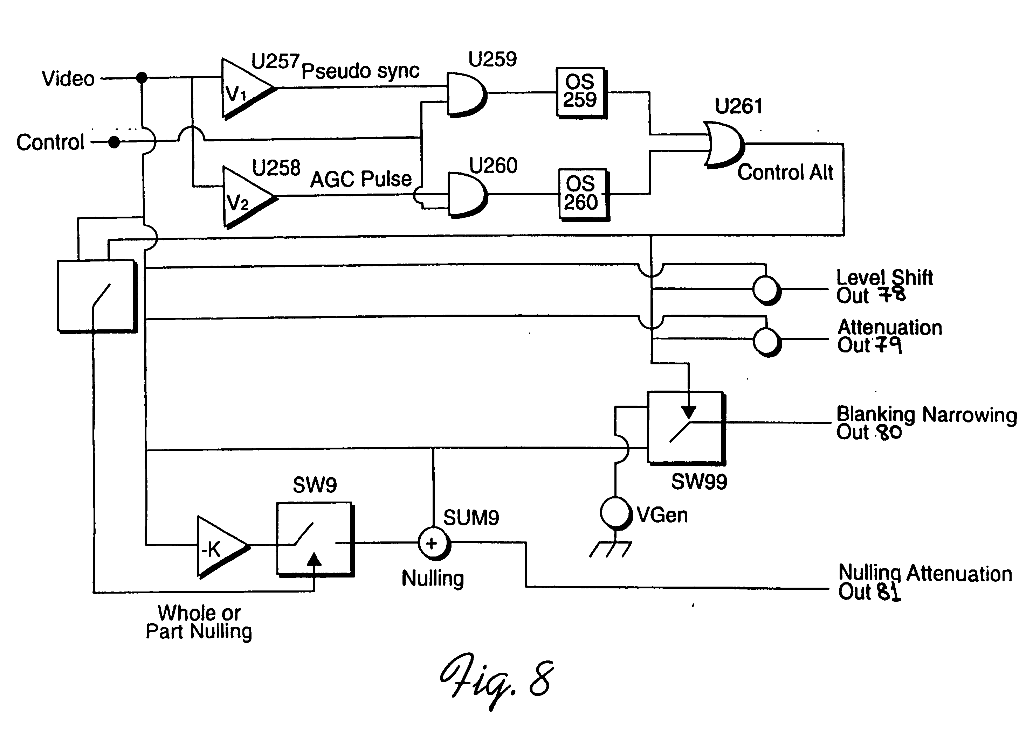

A further embodiment of Circuit ACP 14 is illustrated in Figure 7 and uses a summing circuit to level shift the pseudo sync pulses such that the VCR's circuitry does not sense the level shifted pseudo sync pulses. Thus, and as discussed above with reference to Figure 5, a recordable copy can be made. Preferably there is no or little effect during the normal composite sync pulses and video outside the VBI but excluding the pseudo sync pulses. During the pseudo sync and/or AGC pulses the level can be varied. This is done by way of the control signal 30.

Figure 7 illustrates an embodiment of the Circuit ACP 14 with such a summing: circuit. A copy protected video signal 12 is applied to an input of a summing circuit 44 and the control signal 30 is input to the control element of the summing circuit 44. The produces a level shift output that will perform the various functions described above. The level shifting signal is used to change the relative position of the pseudo sync pulses to the normal sync pulses such that the AGC system within a recorder will not respond sufficiently to the level shifted pseudo sync pulses.

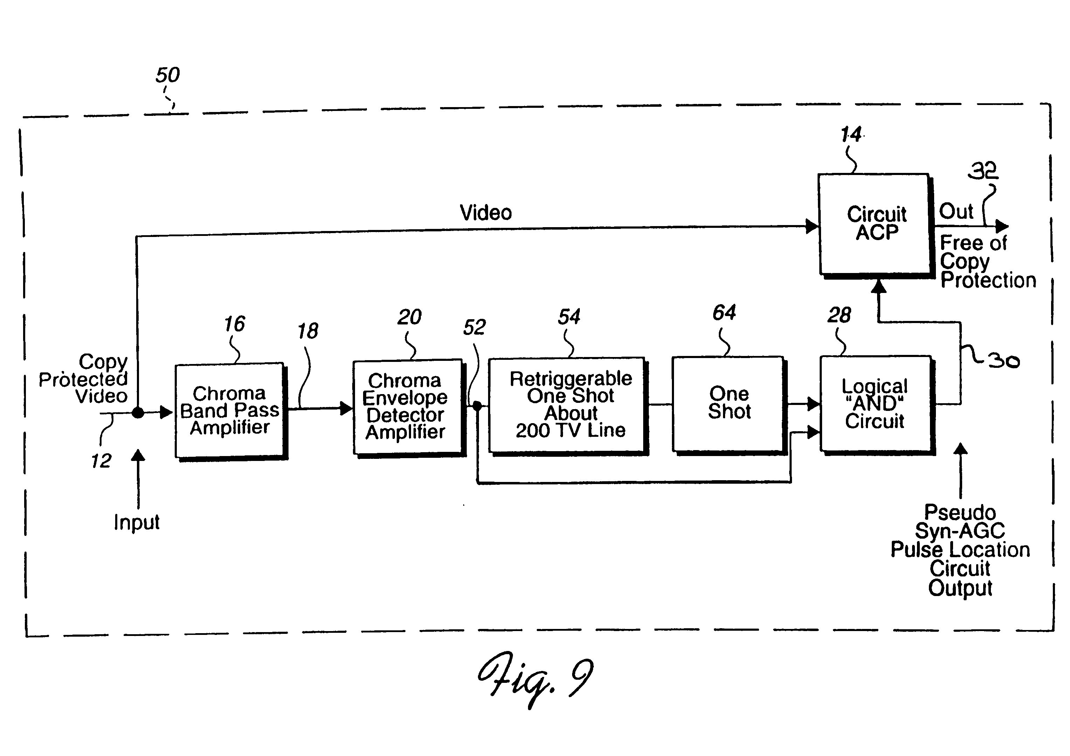

Figure 8 shows a combination of the various Circuit ACP embodiments described above in one package. These include the summing circuit 44, the voltage controlled amplifier 34 and a combination of switch 38 with the voltage generator 42. As described above, the voltage controlled amplifier 34 is arranged to level shift the pseudo-sync pulses and this is achieved by the path in the circuit of Figure 8 having the components U257, U259 and OS259. Similarly, the path in the circuit of Figure 8 having the components U258, U260 and OS260 may be arranged to level shift the AGC pulses. The level shifted pulses are available at output 78. The Control Alt signal generated by OR gate U261 is applied to control switch SW99. This Control Alt control signal is a logic high representing at least a portion of the time when AGC pulses and/or a portion of the time when AGC pulses and/or pseudo sync pulses are on. The output of switch SW99 are narrowed pulses from the voltage generator VGen in combination with the switch SW99. The narrowed pulses are available at output 80. Nulling signals are available at output 81 having been obtained by the attenuation of the video signal input by way of switch SW9 and summing circuit SUM9.

Other "circuit ACP" variations can be circuits that turn logic high by sensing the copy protected video's AGC and pseudo sync pulses. Then timing generators may be used to output pulses shorter in duration than the AGC and pseudo syncs, which in turn is used to narrow the video's AGC pulses and pseudo sync pulses. Of course the copy protection pulses may also be a combination of narrowing, attenuation, level shifting and or modification (i.e. replacement).

The embodiments discussed above have been to locate copy protection signals within the vertical blanking interval and to modify the copy protection signals so as to eliminate them or make them less effective in copy protection.

It is also known to locate copy protection signals on one or more lines within the back porch of a video signal. The methods described herein may similarly be used to eliminate or reduce the effectiveness of these signals.

Figure 9 shows a circuit for detecting the position of positive copy protection pulses clustered in the vertical blanking interval.

In a simple case, it would be possible to couple the chroma envelope pulse from the chroma pulse detector directly to Circuit ACP. However, a more reliable method is illustrated in Figure 9 which shows a detection and modification circuit 50. As previously, the circuit 50 senses color burst or chroma in the horizontal blanking interval to detect the copy protection pulses. As noted above, the color burst or chroma in the horizontal blanking interval signal is not present in the first nine lines of each field. The copy protection pulses are in known locations relative to the period containing no color burst or chroma in the horizontal blanking interval signals.

The detection and modification circuit 50 has an input to which a copy protected video signal 12 may be applied. The input video signal 12 is input to a "Circuit ACP" 14 and to a chroma band pass amplifier 16. Chroma band pass amplifier 16 separates the chroma signal from the luminance signal. The band passed chroma signal 18 is coupled to an envelope detector amplifier 20 to generate a chroma envelope pulse. As shown in Figures 1A, 1B and 1C, the color burst or chroma in the horizontal blanking interval signal is missing for about 9 lines in the vertical blanking interval. The circuitry of Figure 9 takes advantage of this.

The output of chroma envelope detector amplifier 20 is coupled to one shot 54 (timing circuit) having a delay time of about 200 to 250 TV lines. A further one shot 64 receives, and is triggered by, one shot 54's output to generate a pulse coincident with the copy protection pulses. These lines are, for example, the last three lines of the field. This ensures that the output of this circuit triggers off the area of the picture known to have copy protection signals within the back porch of the video signal. The width of these pulses can be made adjustable to accommodate variations of copy protection systems that may incorporate copy protection pulses over greater portions of the picture than presently used. The output of the retriggerable one shot 64 and of the chroma envelope detector amplifier 20 are coupled into logical 'AND' circuit 28 which produces back porch AGC pulse pixel to control 'Circuit ACP' so as to attenuate, clip, blank, replace or level shift the copy protection pulses so as to allow a recordable copy into a video tape recorder.

Circuit ACP can be used in this embodiment to level shift the copy protection pulse, limit the bandwidth to pass only chroma, or replace the copy protection pulse with a normal color burst and blanking level.

It should be noted that in each embodiment, only a sufficient part of the copy protection signal is needed to be modified to produce a defeat of the copy protection signals. This means only a portion of the pseudo sync and or AGC pulses combined with a sufficient number of added pulse pairs and lines of occurrence.

This disclosure is illustrative and not limiting. All discussion in this specification has referred to the NTSC format. However, it will be appreciated that these techniques are also applicable to the PAL and SECAM formats.

Further modifications and variations may be made to the embodiments described and illustrated within the scope of the appended claims.

## Claims

1. A method of removing the effects of pseudo sync and AGC pulse copy protection signals within video lines of a video signal having normal sync pulses including a color burst signal, the copy protection signals being for inhibiting the making of acceptable video recordings of the video signal whilst still allowing the video signal to be viewed, the method comprising the steps of:
determining the presence of a color burst signal to determine which video lines contain said copy protection signals;
generating a control signal during the presence of the copy protection pulses in said video lines, in response to determining the presence of the color burst signal; and
modifying the copy protection signals in response to the control signal in a number of the respective video lines sufficient to allow acceptable video recording of the video signal to be made.

2. A method as claimed in Claim 1, wherein the video signal containing the copy protection signal is in the NTSC, PAL or SECAM format.

3. A method as claimed in Claim 1 or Claim 2, wherein the step of modifying comprises:
increasing an amplitude of all areas of said copy protected video signal except those areas defined by said control signal.

4. A method as claimed in Claim 1 or Claim 2, wherein the step of modifying comprises:
modifying less than all of the lines in which the copy protection signals are present, but sufficient of the lines so that the acceptable video recording can be made.

5. A method as claimed in Claim 1 or Claim 2, wherein the step of modifying comprises:
controlling the gain of portions of said video signal in response to said control signal.

6. A method as claimed in Claim 5, wherein the step of controlling comprises reducing the gain of a voltage controlled amplifier during said presence of said copy protection signals.

7. A method as claimed in Claim 5, wherein the step of controlling comprises increasing the gain of a voltage controlled amplifier during an absence of said copy protection signals within said video signal.

8. A method as claimed in any preceding claim, wherein the step of modifying comprises:
inputting a replacement signal representing the blanking level of said video signal; and
replacing said copy protection signals with said replacement signal in response to said control signal.

9. A method as claimed in any preceding claim, wherein the step of modifying comprises:
increasing the amplitude of said normal sync pulse relative to said pseudo sync pulses in a sufficient number of video lines whereby an acceptable video recording of the video signal can be made.

10. A method as claimed in any preceding claim, wherein:
the step of generating includes detecting a chroma envelope signal and generating in response to said chroma envelope signal a first pulse which encompasses an occurrence of the color burst signal and a second pulse having a duration greater than that of a video line; and
combining the first and second pulses to produce said control signal.

11. A method as claimed in any of Claims 1 to 9, wherein:
the step of generating includes detecting a chroma envelope signal and generating in response to said chroma envelope signal a first pulse which encompasses the possible occurrence of the copy protection signals; and
combining the first pulse and the chroma envelope signal to produce said control signal.

12. Apparatus for removing the effects of pseudo sync and AGC pulse copy protection signals within video lines of a video signal and having normal sync pulses including a color burst signal, the copy protection signals being for inhibiting the making of acceptable video recordings of the video signal whilst still allowing viewing of the video signal, the apparatus comprising:
a location circuit (16, 20, 22, 24, 26, 54, 64) responsive to the color burst signal for determining the presence of the color burst signal to determine which video lines contain said copy protection signals;
a logic circuit (28) responsive to the location circuit for generating a control signal (30) indicative of the presence of the copy protection signals in said determined video lines; and
a copy protection modification circuit (14) for modifying the copy protection signals in a number of the determined video lines sufficient to allow an acceptable video recording of the video signal to be made.

13. Apparatus as claimed in Claim 12, wherein the location circuit includes one-shot means (22, 24, 26) for generating a first pulse which encompasses an occurrence of the color burst signal and a second pulse having a duration greater than that of a video line; and wherein
the logic circuit (28) is arranged to combine the first and second pulses to produce said control signal.

14. Apparatus as claimed in Claim 12 wherein:
the location circuit includes a chroma envelope signal detector (20) for detecting a chroma envelope signal, and
one-shot means (54, 64) for generating a first pulse which encompasses the possible occurrence of the copy protection signals; and wherein
the logic circuit (28) is arranged to combine the first pulse and the chroma envelope signal to produce said control signal.

15. Apparatus as claimed in any of Claims 12 to 14, wherein:
the logic circuit includes an AND circuit (28) for providing the control signal (30) representing the location of said copy protection signals;
the copy protection modification circuit (14) includes circuit means (34, 38, 42, 44) receiving the copy protected video signal for modifying the copy protection signals in response to said control signal; and further comprising
an output terminal (32) for providing a video signal with said copy protection signals modified or removed.

16. Apparatus as claimed in Claim 15, wherein the modification circuit (14) comprises a voltage controlled amplifier (34) responsive to said control signal (30) for increasing an amplitude of all areas of said copy protected video signal except those areas defined by said control pulse.

17. Apparatus as claimed in Claim 15, wherein the modification circuit comprises a voltage controlled amplifier (34) responsive to said control signal for decreasing an amplitude of the areas of said copy protected video signal defined by said control pulse.

18. Apparatus as claimed in Claim 15, wherein the modification circuit modifies less than all of the lines in which the copy protection signals are present, but sufficient of the lines so that an acceptable video recording can be made.

19. Apparatus as claimed in Claim 15, wherein the modification circuit comprises:
a voltage controlled amplifier (34) responsive to said control pulse for controlling the gain of portions of said video signal.

20. Apparatus as claimed in Claim 19, wherein said voltage controlled amplifier reduces the gain during said presence of said copy protection signals.

21. Apparatus as claimed in Claim 19, wherein said voltage controlled amplifier increases the gain during an absence of said copy protection signals within said video signal.

22. Apparatus as claimed in any of Claims 12 to 21, wherein the modification circuit comprises:
means (40, 42) for generating a replacement signal; and
a switch (38) responsive to said control pulse for replacing said copy protection signals with said replacement signal.

23. Apparatus as claimed in Claim 22, wherein said replacement signal is a signal representing the blanking level of said video signal.

24. Apparatus as claimed in Claim 22, wherein said replacement signal is a video signal or a test signal.

25. Apparatus as claimed in Claim 12, wherein the modification circuit (14) is responsive to said control signal for increasing the amplitude of said normal sync timing signal relative to said pseudo sync pulses whereby an acceptable video recording of the video signal can be made.

## Patentansprüche

1. Verfahren zum Entfernen der Effekte von Pseudo-Sync- und AGC-Impuls-Kopierschutzsignalen in Videozeilen von einem Videosignal, das normale Sync-Impulse enthält, die ein Farbburstsignal beinhalten, wobei die Kopierschutzsignale vorgesehen sind, um das Erstellen akzeptierbarer Videoaufzeichnungen des Videosignals zu behindern, wobei es aber immer noch möglich ist, das Videosignal anzusehen, wobei das Verfahren die Schritte beinhaltet:
Bestimmen des Vorhandenseins eines Farbburstsignals, um zu bestimmen, welche Videozeilen die Kopierschutzsignale enthalten;
Erzeugen eines Steuersignals während des Vorhandenseins der Kopierschutzimpulse in den Videozeilen in Reaktion auf das Bestimmen des Vorhandenseins des Farbburstsignals; und
Modifizieren der Kopierschutzsignale in Reaktion auf das Steuersignal in einer Anzahl von jeweiligen Videozeilen, die ausreichend ist, um zu ermöglichen, dass eine akzeptierbare Videoaufzeichnung des Videosignals erstellt werden kann.

2. Verfahren nach Anspruch 1, bei dem das Videosignal, das die Kopierschutzsignale enthält, im NTSC-, PAL- oder SECAM-Format vorliegt.

3. Verfahren nach Anspruch 1 oder Anspruch 2, bei dem der Schritt des Modifizierens umfasst:
Erhöhen einer Amplitude von alle Gebieten des kopiergeschützten Videosignals mit Ausnahme jener Gebiete, die durch das Steuersignal definiert sind.

4. Verfahren nach Anspruch 1 oder Anspruch 2, bei dem der Schritt des Modifizierens umfasst:
Modifizieren von weniger als allen von den Zeilen, in denen die Kopierschutzsignale vorhanden sind, aber eine ausreichende Anzahl von Zeilen, so dass die akzeptierbare Videokopie erstellt werden kann.

5. Verfahren nach Anspruch 1 oder Anspruch 2, bei dem der Schritt des Modifizierens umfasst:
Steuern der Verstärkung von Bereichen des Videosignals in Reaktion auf das Steuersignal.

6. Verfahren nach Anspruch 5, bei dem der Schritt des Steuerns das Reduzieren der Verstärkung von einem spannungsgesteuerten Verstärker während des Vorhandenseins der Kopierschutzsignale beinhaltet.

7. Verfahren nach Anspruch 5, bei dem der Schritt des Steuerns das Erhöhen der Verstärkung von einem spannungsgesteuerten Verstärker während eines Nicht-Vorhandenseins der Kopierschutzsignale in dem Videosignal beinhaltet.

8. Verfahren nach einem der vorhergehenden Ansprüche, bei dem der Schritt des Modifizierens umfasst:
Eingeben eines Ersatzsignals, das den Austastpegel des Videosignals darstellt; und
Ersetzen der Kopierschutzsignale durch das Ersatzsignal in Reaktion auf das Steuersignal.

9. Verfahren nach einem der vorhergehenden Ansprüche, bei dem der Schritt des Modifizierens umfasst:
Erhöhen der Amplitude des normalen Sync-Impulses relativ zu den Psydo-Sync-Impulsen in einer ausreichenden Anzahl von Videozeilen, wodurch eine akzeptierbare Videoaufzeichnung des Videosignals erstellt werden kann.

10. Verfahren nach einem der vorhergehenden Ansprüche, bei dem:
der Schritt des Erzeugens das Erfassen eines Chroma-Hüllkurvensignals und das Erzeugen, in Reaktion auf das Chroma-Hüllkurvensignal, eines ersten Impulses, der ein Auftreten des Farbburstsignals umfasst, und eines zweiten Impulses mit einer Dauer beinhaltet, die größer ist als die einer Videozeile; und
Kombinieren des ersten und zweiten Impulses, um das Steuersignal zu erzeugen.

11. Verfahren nach einem der Ansprüche 1 bis 9, bei dem:
der Schritt des Erzeugens das Erfassen eines Chroma-Hüllkurvensignals und das Erzeugen, in Reaktion auf das Chroma-Hüllkurvensignal, eines ersten Impulses beinhaltet, der das mögliche Auftreten der Kopierschutzsignale umfasst; und
Kombinieren des ersten Impulses und des Chroma-Hüllkurvensignals, um das Steuersignal zu erzeugen.

12. Vorrichtung zum Entfernen der Effekte von Pseudo-Sync- und AGC-Impuls-Kopierschutzsignalen in Videozeilen von einem Videosignal, das normale Sync-Impulse enthält, die ein Farbburstsignal beinhalten, wobei die Kopierschutzsignale vorgesehen sind, um das Erstellen akzeptierbarer Videoaufzeichnungen des Videosignals zu behindern, wobei es immer noch möglich ist, das Videosignal anzusehen, wobei die Vorrichtung aufweist:
eine Lokalisierungsschaltung (16, 20, 22, 24, 26, 54, 64), die auf das Farbburstsignal anspricht, um das Vorhandensein des Farbburstsignals zu bestimmen, um zu bestimmen, welche Videozeilen die Kopierschutzsignale beinhalten;
eine Logikschaltung (28), die auf die Lokalisierungsschaltung anspricht, um ein Steuersignal (30) zu erzeugen, das das Vorhandensein der Kopierschutzsignale in den bestimmten Videozeilen angibt; und
eine Kopierschutzmodifikationsschaltung (14), um die Kopierschutzsignale in einer Anzahl der bestimmten Videozeilen zu modifizieren, die ausreichend ist, um zu ermöglichen, dass eine akzeptierbare Videoaufzeichnung des Videosignals erstellt werden kann.

13. Vorrichtung nach Anspruch 12, bei der die Lokalisierungsschaltung eine monostabile Einrichtung (22, 24, 26) aufweist, um einen ersten Impuls, der das Auftreten des Farbburstsignals umfasst, und einen zweiten Impuls zu erzeugen, der eine Dauer hat, die größer ist als die einer Videozeile; und wobei die Logikschaltung (28) dazu ausgestaltet ist, um den ersten und zweiten Impulse zu kombinieren, um das Steuersignal zu erzeugen.

14. Vorrichtung nach Anspruch 12, bei der:
die Lokalisierungsschaltung einen Chroma-Hüllkurvensignaldetektor (20) aufweist, um ein Chroma-Hüllkurvensignal zu erfassen; und
eine monostabile Einrichtung (54, 64) aufweist, um einen ersten Impulse zu erzeugen, der das mögliche Auftreten der Kopierschutzsignale umfasst; und wobei
die Logikschaltung (28) dazu ausgestaltet ist, um den ersten Impuls und das Chroma-Hüllkurvensignal zu kombinieren, um das Steuersignal zu erzeugen.

15. Vorrichtung nach einem der Ansprüche 12 bis 14, bei der:
die Logikschaltung eine UND-Schaltung (28) aufweist, um das Steuersignal (30) zur Verfügung zu stellen, das die Position der Kopierschutzsignale angibt;
die Kopierschutzmodifikationsschaltung (14) eine Schaltungseinrichtung (34, 42, 44) beinhaltet, die das kopiergeschützte Videosignal empfängt, um die Kopierschutzsignale in Reaktion auf das Steuersignal zu modifizieren; und außerdem mit
einem Ausgangsanschluss (32), um ein Videosignal zur Verfügung zu stellen, wobei die Kopierschutzsignale modifiziert oder entfernt sind.

16. Vorrichtung nach Anspruch 15, bei der die Modifikationsschaltung (14) einen spannungsgesteuerten Verstärker (34) aufweist, der auf das Steuersignal (30) anspricht, um eine Amplitude von allen Gebieten des kopiergeschützten Videosignals zu erhöhen, mit Ausnahme jener Gebiete, die durch den Steuerimpuls definiert sind.

17. Vorrichtung nach Anspruch 15, bei der die Modifikationsschaltung einen spannungsgesteuerten Verstärker (34) aufweist, der auf das Steuersignal anspricht, um eine Amplitude der Gebiete des kopiergeschützten Videosignals zu vermindern, die durch den Steuerimpuls definiert sind.

18. Vorrichtung nach Anspruch 15, bei der die Modifikationsschaltung weniger als alle von den Linien modifiziert, in denen die Kopierschutzsignale vorhanden sind, aber eine ausreichende Anzahl von Linien, so dass eine akzeptierbare Videoaufzeichnung erstellt werden kann.

19. Vorrichtung nach Anspruch 15, bei der die Modifikationsschaltung aufweist:
einen spannungsgesteuerten Verstärker (34), der auf den Steuerimpuls anspricht, um die Verstärkung von Bereichen des Videosignals zu steuern.

20. Vorrichtung nach Anspruch 19, bei der der spannungsgesteuerte Verstärker die Verstärkung während des Vorhandenseins der Kopierschutzsignale vermindert.

21. Vorrichtung nach Anspruch 19, bei der der spannungsgesteuerte Verstärker die Verstärkung während eines Nicht-Vorhandenseins der Kopierschutzsignale in dem Videosignal erhöht.

22. Vorrichtung nach einem der Ansprüche 12 bis 21, bei der die Modifikationsschaltung aufweist:
eine Einrichtung (40, 42) zum Erzeugen eines Ersatzsignals; und
einen Schalter (38), der auf den Steuerimpuls anspricht, um die Kopierschutzsignale durch das Ersatzsignal zu ersetzen.

23. Vorrichtung nach Anspruch 22, bei der das Ersatzsignal ein Signal ist, das den Austastpegel von dem Videosignal darstellt.

24. Vorrichtung nach Anspruch 22, bei der das Ersatzsignal ein Videosignal oder ein Testsignal ist.

25. Vorrichtung nach Anspruch 12, bei der die Modifikationsschaltung (14) auf das Steuersignal anspricht, um die Amplitude des normalen Sync-Zeitsignals relativ zu den Pseudo-Sync-Impulsen zu erhöhen, wodurch eine akzeptierbare Videoaufzeichnung des Videosignal erstellt werden kann.

## Revendications

1. Procédé pour enlever les effets des signaux de protection contre la copie d'une impulsion de pseudo-synchronisation et de commande automatique de gain dans des lignes vidéo d'un signal vidéo ayant des impulsions de synchronisation normale incluant un signal de salve de couleur, les signaux de protection contre la copie étant destinés à empêcher la réalisation d'enregistrements vidéo acceptables du signal vidéo tout en permettant encore au signal vidéo d'être vu, le procédé comprenant les étapes qui consistent à :
déterminer la présence d'un signal de salve de couleur pour déterminer quelles sont les lignes vidéo qui contiennent lesdits signaux de protection contre la copie ;
générer un signal de commande pendant la présence des impulsions de protection contre la copie dans lesdites lignes vidéo, en réponse à la détermination de la présence du signal de salve de couleur ; et
modifier les signaux de protection contre la copie en réponse au signal de commande dans un nombre de lignes vidéo respectives suffisant pour permettre la réalisation d'un enregistrement vidéo acceptable du signal vidéo.

2. Procédé selon la revendication 1, dans lequel le signal vidéo contenant le signal de protection contre la copie est au format NTSC, PAL ou SECAM.

3. Procédé selon la revendication 1 ou la revendication 2, dans lequel l'étape de modification comprend :
l'augmentation d'une amplitude de toutes les zones dudit signal vidéo protégé contre la copie à l'exception des zones définies par ledit signal de commande.

4. Procédé selon la revendication 1 ou la revendication 2, dans lequel l'étape de modification comprend :
la modification de moins de la totalité des lignes dans lesquelles les signaux de protection contre la copie sont présents, mais de suffisamment de lignes pour que l'enregistrement vidéo acceptable puisse être réalisé.

5. Procédé selon la revendication 1 ou la revendication 2, dans lequel l'étape de modification comprend :
la commande du gain de parties dudit signal vidéo en réponse audit signal de commande.

6. Procédé selon la revendication 5, dans lequel l'étape de commande comprend la réduction du gain d'un amplificateur à tension asservie pendant ladite présence desdits signaux de protection contre la copie.

7. Procédé selon la revendication 5, dans lequel l'étape de commande comprend l'augmentation du gain d'un amplificateur à tension asservie pendant une absence desdits signaux de protection contre la copie dans ledit signal vidéo.

8. Procédé selon l'une quelconque des revendications précédentes, dans lequel l'étape de modification comprend :
l'entrée d'un signal de remplacement représentant le niveau de suppression dudit signal vidéo ; et
le remplacement desdits signaux de protection contre la copie par ledit signal de remplacement en réponse audit signal de commande.

9. Procédé selon l'une quelconque des revendications précédentes, dans lequel l'étape de modification comprend :
l'augmentation de l'amplitude de ladite impulsion de synchronisation normale par rapport auxdites impulsions de pseudo-synchronisation dans un nombre suffisant de lignes vidéo, ce par quoi un enregistrement vidéo acceptable du signal vidéo peut être réalisé.

10. Procédé selon l'une quelconque des revendications précédentes, dans lequel :
l'étape de génération comprend la détection d'un signal d'enveloppe de chrominance et la génération en réponse audit signal d'enveloppe de chrominance d'une première impulsion qui englobe une occurrence du signal de salve de couleur et une deuxième impulsion ayant une durée supérieure à celle d'une ligne vidéo ; et
la combinaison des première et deuxième impulsions pour produire ledit signal de commande.

11. Procédé selon l'une quelconque des revendications 1 à 9, dans lequel :
l'étape de génération comprend la détection d'un signal d'enveloppe de chrominance et la génération en réponse audit signal d'enveloppe de chrominance d'une première impulsion qui englobe la possible occurrence des signaux de protection contre la copie ; et
la combinaison de la première impulsion et du signal d'enveloppe de chrominance pour produire ledit signal de commande .

12. Appareil pour enlever les effets des signaux de protection contre la copie d'une impulsion de pseudo-synchronisation et de commande automatique de gain dans des lignes vidéo d'un signal vidéo et ayant des impulsions de synchronisation normale comprenant un signal de salve de couleur, les signaux de protection contre la copie étant destinés à empêcher la réalisation d'enregistrements vidéo acceptables du signal vidéo tout en permettant encore au signal vidéo d'être vu, l'appareil comprenant :
un circuit de repérage (16, 20, 22, 24, 26, 54, 64) réagissant au signal de salve de couleur servant à déterminer la présence du signal de salve de couleur pour déterminer quelles sont les lignes vidéo qui contiennent lesdits signaux de protection contre la copie ;
un circuit logique (28) réagissant au circuit de repérage servant à générer un signal de commande (30) indicatif de la présence des signaux de protection contre la copie dans lesdites lignes vidéo déterminées ; et
un circuit de modification de la protection contre la copie (14) servant à modifier les signaux de protection contre la copie dans un nombre de lignes vidéo déterminées suffisant pour permettre la réalisation d'un enregistrement vidéo acceptable du signal vidéo.

13. Appareil selon la revendication 12, dans lequel le circuit de repérage comprend un moyen direct (22, 24, 26) pour générer une première impulsion qui englobe une occurrence du signal de salve de couleur et une deuxième impulsion ayant une durée supérieure à celle d'une ligne vidéo ; et dans lequel
le circuit logique (28) est agencé pour combiner les première et deuxième impulsions pour produire ledit signal de commande.

14. Appareil selon la revendication 12, dans lequel :
le circuit de repérage comprend un détecteur de signal d'enveloppe de chrominance (20) servant à détecter un signal d'enveloppe de chrominance, et
un moyen direct (54, 64) servant à générer une première impulsion qui englobe la possible occurrence des signaux de protection contre la copie ; et dans lequel
le circuit logique (28) est agencé pour combiner la première impulsion et le signal d'enveloppe de chrominance pour produire ledit signal de commande.

15. Appareil selon l'une quelconque des revendications 12 à 14, dans lequel :
le circuit logique comprend un circuit ET (28) servant à délivrer le signal de commande (30) représentant l'emplacement desdits signaux de protection contre la copie ;
le circuit de modification de la protection contre la copie (14) comprend un moyen de circuit (34, 42, 44) recevant le signal vidéo protégé contre la copie servant à modifier les signaux de protection contre la copie en réponse audit signal de commande ; et comprenant de plus
une borne de sortie (32) pour délivrer un signal vidéo avec lesdits signaux de protection contre la copie modifiés ou supprimés.

16. Appareil selon la revendication 15, dans lequel le circuit de modification (14) comprend un amplificateur à tension asservie (34) réagissant audit signal de commande (30) pour augmenter une amplitude de toutes les zones dudit signal vidéo protégé contre la copie à l'exception des zones définies par ladite impulsion de commande.

17. Appareil selon la revendication 15, dans lequel le circuit de modification comprend un amplificateur à tension asservie (34) réagissant audit signal de commande (30) pour diminuer une amplitude des zones dudit signal vidéo protégé contre la copie définies par ladite impulsion de commande .

18. Appareil selon la revendication 15, dans lequel le circuit de modification modifie moins de la totalité des lignes dans lesquelles les signaux de protection contre la copie sont présents, mais suffisamment de lignes pour qu'un enregistrement vidéo acceptable puisse être réalisé.

19. Appareil selon la revendication 15, dans lequel le circuit de modification comprend :
un amplificateur à tension asservie (34) réagissant à ladite impulsion de commande pour commander le gain de parties dudit signal vidéo.

20. Appareil selon la revendication 19, dans lequel ledit amplificateur à tension asservie réduit le gain pendant ladite présence desdits signaux de protection contre la copie.

21. Appareil selon la revendication 19, dans lequel ledit amplificateur à tension asservie augmente le gain pendant une absence desdits signaux de protection contre la copie dans ledit signal vidéo.

22. Appareil selon l'une quelconque des revendications 12 à 21, dans lequel le circuit de modification comprend :
un moyen (40, 42) pour générer un signal de remplacement ; et
un commutateur (38) réagissant à ladite impulsion de commande pour remplacer lesdits signaux de protection contre la copie par ledit signal de remplacement.

23. Appareil selon la revendication 22, dans lequel ledit signal de remplacement est un signal représentant le niveau de suppression dudit signal vidéo.

24. Appareil selon la revendication 22, dans lequel ledit signal de remplacement est un signal vidéo ou un signal de test.

25. Appareil selon la revendication 12, dans lequel le circuit de modification (14) réagit audit signal de commande pour augmenter l'amplitude dudit signal d'horloge de synchronisation normale par rapport auxdites impulsions de pseudo-synchronisation, ce par quoi un enregistrement vidéo acceptable du signal vidéo peut être réalisé.
